# EUROPEAN PATENT APPLICATION

(11) **EP 4 787 216 A1**
(43) Date of publication of application: **05.08.2026**
(21) Application number: 25159818.1
(22) Date of filing: 25.02.2025
(51) Int. Cl.: G06F 30/15, G05B 17/00, G05B 17/02, G06F 30/20

(54) **METHOD AND SYSTEM FOR VIRTUALIZATION OF ELECTRONIC CONTROL SYSTEMS FOR DIGITAL TWIN APPLICATIONS**

(30) Priority: 30.01.2025 EP 25155018
(71) Applicant: AUMOVIO Germany GmbH, 60488 Frankfurt am Main (DE)
(72) Inventor: Hermann, Torsten, 30175 Hannover (DE); Hruschka, Martin, 30175 Hannover (DE); Bleicher, Wolfgang, 30175 Hannover (DE)
(74) Representative: Aumovio Corporation

(57) **Abstract**

Embodiments of the present disclosure relate to methods for virtualizing an electronic control system. A computer program, a computer-readable data carrier and an apparatus are also disclosed. The method comprising: abstracting, technical details of signals in ECS components into groups, including analog signals group and digital signals group; obtaining peripheral models associated with respective ECS components, wherein each peripheral model comprises interfaces that correspond to respective interfaces of the respective ECS component, each interface of the peripheral model being associated with a signal, which is an analog signal or a digital signal, matching an interface signal of the respective ECS component; obtaining signal operations that represent signal processing of the respective ECS components, said signal operations including logical operations for the digital signals, and mathematical operations for the analog signals; and executing the signal operations to evaluate the signal processing between the ECS components.

## Description

The present invention relates to the virtualization and abstraction of automotive electronic control systems for digital twin applications, specifically focusing on the integration and simulation of peripheral models, signal processing, and the creation of a scalable and efficient virtual environment for testing and validating Electronic Control Systems (ECSs).

In the automotive industry, the development and testing of ECSs are critical for ensuring the reliability and performance of various vehicle systems, such as Anti-lock Braking Systems (ABS), Advanced Driver Assistance Systems (ADAS), engine control, and transmission control. ECUs interact with numerous peripheral devices, including sensors and actuators, which generate and process signals essential for the proper functioning of the vehicle.

Current methods for integrating and testing peripheral devices face several challenges. One significant issue is the complexity of signal processing. Signals from peripherals, such as wheel speed sensors and brake light indicators, vary widely in their characteristics. Technical signals, including voltages and currents, and logical signals, such as digital IO and PWM, are often mixed, leading to increased complexity in signal processing and analysis.

Another challenge is scalability. The vast number of different peripherals requires a scalable approach to integration. Existing systems often lack a common interface, making it difficult to add new peripherals or update existing ones without significant modifications to the overall system.

Real-world signal properties also pose a challenge. Real-world signals are subject to various physical influences, such as temperature and transient behaviors, which complicate the simulation and analysis process. Simplifying these properties without losing essential information is a significant challenge.

Validation and verification are crucial for reliable testing. Ensuring that the virtual model accurately represents the real hardware is essential. Current methods may lack comprehensive validation checks, leading to discrepancies between the virtual and real systems.

Finally, efficient signal evaluation is necessary. The wiring and evaluation of signals in complex systems require efficient methods to ensure accurate and timely processing. Existing approaches may not adequately address the need for simple parsing and recursive evaluation of logical terms.

The method and system for virtualizing and abstracting an electronic control system disclosed herein involves several key components and processes to ensure efficient and reliable virtualization of the operation of said ECS. The method and system are designed to handle both analog and digital signals, providing a comprehensive framework for signal processing, malfunction detection, and correction.

The method begins with signal abstraction, which includes categorizes signals from ECS components into two groups: analog signals (e.g., voltages, currents) and digital signals (e.g., digital input/output (DIO), pulse width modulation (PWM)). This categorization simplifies the processing paths for different signal types or groups, ensuring that each type or group of signals is handled appropriately.

The method comprises signal operations for creating and implementing operations to virtualize signal processing. For digital signals, logical operations such as AND, OR, XOR, and NOT are defined. For analog signals, mathematical operations such as at least one of multiplication (MUL), addition (ADD), division (DIV) and subtraction (SUB). These operations are implemented using prefix notation for wiring or connection descriptions (e.g. wiring or connections between the respective ECS components), enabling simple parsing and recursive evaluation of complex logical terms through pre-order traversal of a tree structure.

The method comprises encapsulating peripheral models of the ECS components behind a standardized interface. Each peripheral model may have a number of pins equal to that in the corresponding ECS component, with each pin associated with either an analog or digital signal. Pins are identified by unique names and designated as either input or output, ensuring compatibility and ease of integration for future peripheral models.

The method comprises malfunction detection and correction for continuously monitoring signals to identify anomalies and generate diagnostic codes. It analyzes sensor data to detect malfunctions and applies corrections through software-based methods (e.g., recalibration, firmware updates) and hardware-based methods (e.g., signal re-routing, component replacement). Corrections are integrated into both the virtual environment and the real-life ECS components, ensuring continuous and reliable operation.

During startup, the method performs validation checks to ensure that the peripheral models accurately represent the real hardware. This includes syntax-, semantic-, compatibility-, and consistency-checks. The also provides efficient simulation and feedback, enabling continuous monitoring and optimization of the electronic control unit (ECU) performance under various simulated conditions.

Overall, this method provides a robust and scalable solution for virtualizing and abstracting ECS components, enhancing the development, testing, and validation processes while ensuring the reliability and efficiency of the system. The method is enclosed by the subject-matter of the appended independent claims. The appended dependent claims address optional embodiments of the present disclosure.

According to one aspect of the present disclosure, there is provided a method for virtualizing an electronic control system, ECS, comprising: abstracting, technical details of signals in ECS components into groups, including analog signals group and digital signals group, wherein the groups are strictly separated, thereby facilitating distinct processing paths for different signal types; obtaining peripheral models associated with respective ECS components, wherein each peripheral model comprises interfaces that correspond to respective interfaces of the respective ECS component, each interface of the peripheral model being associated with a signal, which is an analog signal or a digital signal, an input signal or an output signal, matching an interface signal of the respective ECS component, said signal can be acquired from the respective interface of the respective ECS component; obtaining, for simulating signal processing between the peripheral models, signal operations to virtualize signal processing between the respective ECS component, said signal operations including logical operations for the digital signals, and mathematical operations for the analog signals, thereby providing a unified framework for signal processing; executing the signal operations to evaluate the signal processing between the ECS components; using said evaluation of the signal processing to identify malfunctions of the ECS components; and adapting the malfunctioning ECS component to function properly, thereby ensuring continuous and reliable operation of the ECS.

By abstracting the technical details of signals in ECS components into distinct groups, including analog signals and digital signals, the method facilitates distinct processing paths for different signal types. This separation enhances the efficiency a of signal processing by allowing tailored operations for each signal type, thereby reducing the complexity of handling mixed signal types.

For example, the abstraction of said signal details may include representing analog signals as floating-point values for precise mathematical operations, simplifying digital signals to binary states for straightforward logical processing, and/or reducing PWM signals to their duty cycles to avoid complex state simulations. By removing transient behaviors and assuming ideal conditions, the method ensures efficient and accurate signal processing, significantly enhancing the virtualization of ECS components compared to state-of-the-art methods.

For example, in an Anti-lock Braking System (ABS), wheel speed sensors generate analog signals, while brake light indicators generate digital signals. By categorizing these signals, the system can process each type more efficiently, ensuring accurate and timely responses.

For example, the abstraction of said signal details may comprise representing only the input-output relationships of each ECS component or chip (e.g. rather than the complex internal signal processing), or may simply read or measure the input and output of the respective ECS components and assign them to the respective interfaces of the respective peripheral model. This approach simplifies the virtualization process, reduces computational complexity, and enhances the efficiency and accuracy of signal processing. For instance, by removing transient behaviors and assuming ideal conditions, the method ensures efficient signal processing, significantly improving the virtualization of ECS components compared to state-of-the-art methods. For example, a temperature sensor's output can be accurately represented and adjusted using floating-point arithmetic, while digital signals indicating the status of door locks can be processed using straightforward logical operations like AND, OR, and XOR.

Obtaining peripheral models associated with respective ECS components, where each peripheral model comprises interfaces that correspond to the respective ECS component's interfaces, ensures that the virtualization accurately reflects the physical system. Each interface of the peripheral model is associated with a signal, either analog or digital, input or output, matching the interface signal of the respective ECS component. This correspondence ensures that the virtual model or the digital twin model comprising the peripheral models can interact seamlessly with the actual ECS components, providing a reliable representation of the system.

For instance, a peripheral model for an engine control unit (ECU) would have interfaces for various sensors and actuators, such as temperature sensors and fuel injectors, matching the real ECU's interfaces. The operation of the ECS components and the internal signal processing are thereby abstracted and bypassed, with the peripheral model representing a black box in this respect. This abstraction allows for quick and efficient simulation without delving into the internal complexities of the ECS components.

The method further includes obtaining, for simulating signal processing between the peripheral models, signal operations that represent signal processing between the respective ECS components. These signal operations include logical operations for the digital signals and mathematical operations for the analog signals, thereby providing a unified framework for signal processing. For example, logical operations like AND, OR, and NOT can be used to process digital signals from a transmission control unit (TCU), while mathematical operations like addition and multiplication can be used to process analog signals from an engine control unit (ECU).

The method involves executing the signal operations to evaluate the signal processing between the ECS components. This step ensures that the interactions between different ECS components are accurately simulated and evaluated. For instance, executing signal operations can help simulate the interaction between the ABS and the traction control system (TCS), ensuring that both systems work together seamlessly to maintain vehicle stability.

The method uses the evaluation of the signal processing to identify malfunctions of one or more of the ECS components. By analyzing the results of the signal processing evaluation, the system can detect anomalies and identify malfunctioning components. For example, if the evaluation reveals that the brake light indicator is not responding correctly, the system can identify this as a malfunction in the brake light circuit.

Finally, the method comprises adapting the malfunctioning ECS components to function properly, thereby ensuring continuous and reliable operation of the ECS. This can involve both software-based and hardware-based corrections. For instance, if a sensor is found to be malfunctioning, the system can recalibrate the sensor or apply a firmware update to correct the issue. If the problem is hardware-related, such as a faulty sensor, the system can suggest replacing the sensor to restore proper functionality. By abstracting and bypassing the internal signal processing of the ECS components, the method provides a quick and efficient simulation that enhances the development, testing, and validation processes.

In embodiments, abstracting the signal properties of the ECS components may further comprises abstracting signal properties of the ECS components to reduce complexity and facilitate analysis, including simplifying transient behaviors and assuming ideal physical influencing factors, thereby enabling more efficient signal processing.

By simplifying transient behaviors and assuming ideal physical influencing factors, the method reduces the computational burden associated with processing fluctuating signals and complex environmental conditions. For example, instead of accounting for every minor fluctuation in a temperature sensor's output due to transient behaviors, the method assumes a stable signal, which simplifies the analysis and processing. This leads to more efficient signal processing, as the system can focus on stable, consistent data rather than constantly adjusting for transient variations.

In embodiments, abstracting the signal properties of the ECS components may further comprise: representing accuracies of analog signal values as floating-point values; and representing digital signal values as binary states.

Representing analog signals as floating-point values ensures precise and consistent mathematical operations, such as calibration adjustments. For instance, a temperature sensor's output voltage can be accurately represented and adjusted using floating-point arithmetic, ensuring high precision in temperature readings. Representing digital signals as binary states simplifies the logical processing of these signals. For example, a digital input indicating whether a switch is on or off can be represented as 0 or 1, making it straightforward to apply logical operations like AND, OR, and XOR. This abstraction reduces the complexity of handling digital signals, as the system only needs to process binary states rather than varying voltage levels.

Overall, these abstractions enable more efficient and accurate signal processing by focusing on stable signal properties and simplifying the representation of analog and digital signals. This approach enhances the performance and reliability of the virtualized ECS, making it easier to analyze and optimize the system's behavior.

In embodiments, the logical operations include at least one of AND, OR, XOR, and NOT for digital signals, and the mathematical operations include at least one of multiplication, MUL, and addition, ADD, for analog signals.

For example, consider the digital signals used to indicate the status of door locks (locked or unlocked) and the state of lights (on or off). Logical operations can be applied to these signals within the simulation to detect potential malfunctions. An AND operation could be used to verify that the interior lights turn on only when the doors are unlocked and the ignition is off. If the simulation detects that the lights are on while the doors are locked, it can flag this as a potential malfunction. Similarly, an OR operation could be used to check if the hazard lights activate correctly when any door is open or if the vehicle is in an emergency state. If the hazard lights fail to activate under these conditions in the simulation, it indicates a malfunction.

For analog signals, such as those from temperature sensors in the climate control system, mathematical operations like multiplication and addition can be used to simulate and detect malfunctions. For instance, the simulation can average temperature readings from multiple sensors using addition and division to ensure consistent climate control. If the averaged temperature reading deviates significantly from expected values, the simulation can identify this as a potential sensor malfunction. Multiplication might be used to simulate the fan speed adjustment based on the temperature difference from a set point. If the fan speed does not adjust correctly in the simulation, it can indicate a malfunction in the climate control system.

The advantages of these operations in the context of a digital twin or simulation include improved efficiency and accuracy in detecting malfunctions. Logical operations ensure that digital signals are processed in a straightforward and predictable manner, making it easier to identify discrepancies and potential issues. Mathematical operations allow for precise simulation of analog signal behavior, enabling accurate detection of deviations from expected performance. Overall, these operations enhance the ability to quickly and efficiently simulate the ECS, providing valuable insights into potential malfunctions and, in this case, contributing to the reliability and safety of the electric vehicle.

By using these logical and mathematical operations, the system can accurately simulate the interactions between different ECS components, ensuring that the virtual model behaves similarly to the real-world system. This approach allows for efficient testing and validation of the ECS, improving the reliability and performance of the vehicle's electronic control systems.

In embodiments, executing the signal operations to evaluate the signal processing between the ECS components may comprise: implementing the signal operations using prefix notation for wiring descriptions (or connections descriptions, e.g. description of the wirings or connections between the respective ECS components associated with the respective models), wherein each signal operation is specified before its operands to enable simple parsing and recursive evaluation of complex logical terms representing the signal processing between the ECS components; and performing signal processing evaluation via pre-order traversal of a tree structure.

In embodiments, implementing the signal operations using prefix notation for wiring descriptions may comprise: describing wiring of signals between the ECS components using prefix notation, wherein each signal operation is specified before its operands; parsing the prefix notation to construct a tree structure representing the signal operations; and performing signal processing evaluation via pre-order traversal of the tree structure, ensuring efficient processing and accurate evaluation of complex logical terms.

By specifying each signal operation before its operands in prefix notation, the method enables simple parsing and recursive evaluation of complex logical terms. This approach reduces the complexity of interpreting and processing signal operations, ensuring that the system can efficiently handle intricate signal processing tasks. For example, a logical operation like AND, which determines if multiple conditions are met, can be easily parsed and evaluated when specified in prefix notation.

Furthermore, describing the wiring of signals using prefix notation allows for the construction of a tree structure representing the signal operations. Parsing this notation to build the tree structure ensures that the relationships between different signal operations are clearly defined and organized. This structured representation facilitates the accurate evaluation of signal processing, as each node in the tree corresponds to a specific operation, and the branches represent the operands.

Performing signal processing evaluation via pre-order traversal of the tree structure ensures that each operation is processed in the correct sequence. By visiting the root node first and then recursively visiting the left and right subtrees, the method guarantees that all dependencies are resolved before an operation is executed. This approach enhances the efficiency and accuracy of signal processing, as it ensures that each operation is evaluated only after all its prerequisites have been processed. Overall, these technical effects contribute to a robust and efficient framework for evaluating signal processing in ECS components, enabling precise and reliable detection of malfunctions and optimization of system performance.

In embodiments, the method for virtualizing the ECS may further comprise performing validation checks during startup of the method or of a system executing the method, the validation checks including at least one of syntax checks, semantic checks, compatibility checks, and consistency checks, thereby ensuring the peripheral models accurately represents the respective ECS components.

In embodiments, the validation checks during startup may further comprise: performing syntax checks to ensure correct use of parentheses; performing semantic checks to ensure operations are correct; performing compatibility checks to ensure no mixing of incompatible signal groups; and performing consistency checks to ensure connections are valid, comprising not connecting input to input or output to output.

These validation checks, including syntax checks, semantic checks, compatibility checks, and consistency checks, ensure that the peripheral models accurately represent the respective ECS components.

Performing syntax checks to ensure the correct use of parentheses guarantees that the signal operations are syntactically correct, preventing errors during parsing and evaluation. For example, ensuring that all parentheses are properly matched and nested avoids misinterpretation of the signal operations, which could lead to incorrect processing.

Semantic checks ensure that the operations are logically correct and adhere to predefined rules. This includes verifying that operations make sense within the context of the ECS, such as ensuring that there is a maximum of one pulse width modulation (PWM) signal per operation. These checks prevent logical errors that could compromise the accuracy and reliability of the signal processing.

Compatibility checks ensure that there is no mixing of incompatible signal groups, such as analog and digital signals. By verifying that signals from different groups are not incorrectly combined, the method maintains the integrity of the signal processing paths. For instance, preventing an analog signal from being used in a digital operation avoids processing errors and ensures that each signal type is handled appropriately.

Consistency checks ensure that connections between signals are valid, such as not connecting input to input or output to output. These checks maintain the logical consistency of the signal processing network, preventing invalid connections that could disrupt the operation of the ECS. For example, ensuring that an output signal is not mistakenly connected to another output signal avoids conflicts and ensures proper data flow.

In embodiments, the method for virtualizing an ECS may further comprising processing signals between the peripheral models in a sequence to ensure updated data, including sorting nodes and edges in a graph to ensure each node is processed only after all its dependencies have been processed.

By sorting nodes and edges in a graph to ensure each node is processed only after all its dependencies have been processed, the method guarantees that data is handled in the correct order, maintaining the accuracy and reliability of the ECS.

One technical effect is the prevention of outdated data processing. By ensuring that each node is processed only after all its dependencies have been resolved, the method avoids scenarios where nodes operate on stale or incomplete data. For example, in an electric vehicle's zone control unit, if the temperature sensor's data is processed before the fan controller, the fan controller will always have the most recent temperature information, ensuring accurate climate control.

Another technical effect is the enhancement of system stability. The method leverages the fact that the wiring does not contain cycles between peripherals, with the only feedback channel leading back to the microcontroller. This absence of cycles ensures that the system can stabilize, as there are no circular dependencies that could cause infinite loops or unstable behavior. By sorting the nodes and edges, the method ensures a clear and logical processing sequence, contributing to the overall stability of the ECS.

Additionally, the method improves the efficiency of signal processing. By organizing the nodes and edges into a structured sequence, the method facilitates efficient data flow and processing. This structured approach reduces the computational complexity associated with handling dependencies dynamically, allowing for faster and more reliable signal processing. For instance, in a simulation or digital twin environment, this efficient processing enables quick detection and diagnosis of malfunctions, enhancing the system's responsiveness and reliability.

In embodiments, adapting the malfunctioning ECS component to function properly comprises software-based corrections and/or hardware-based corrections.

In embodiments, the software-based corrections comprise at least one of: recalibration by adjusting software parameters associated with the ECS components to correct minor deviations of the malfunctioning ECS components output; firmware updates by applying updates to fix software bugs or improve performance to malfunctioning ECS components; and reset commands by sending reset commands to reinitialize malfunctioning ECS components.

In embodiments, the hardware-based corrections comprise at least one of: signal re-routing comprising sending signals to the corresponding malfunctioning ECS component to temporarily reroute signals to bypass the malfunctioning ECS components; component replacement comprising identifying a need for physical replacement of faulty sensors or actuators in the malfunctioning ECS components and sending a feedback to a user; and wiring repairs comprising detecting and suggesting repairs for damaged or corroded wiring inside and/or outside the malfunctioning ECS component.

The technical effects of adapting malfunctioning ECS components to function properly through software-based and/or hardware-based corrections include enhanced system reliability and minimized downtime. Software-based corrections, such as recalibration, firmware updates, and reset commands, allow for quick and efficient resolution of minor deviations and software bugs, ensuring the ECS components operate correctly without the need for physical intervention. Hardware-based corrections, including signal re-routing, component replacement, and wiring repairs, address more severe issues by bypassing, replacing, or repairing faulty components, thereby maintaining the integrity and functionality of the ECS. These combined approaches ensure continuous and reliable operation of the ECS, enhancing overall system performance and longevity.

According to another aspect of the present disclosure there is provided a system for virtualizing and electronic control system, ECS, comprising: a signal categorization module (210) configured to abstract signals in ECS components (202), comprising categorizing said signals into categorized groups, including analog signals group (215) and digital signals group (220), thereby facilitating distinct processing paths for different signal groups; a standardized interface module (203) configured to encapsulate peripheral models (204) with respective ECS components (202), each peripheral model comprising interfaces that correspond to respective interfaces of the respective ECS component, each interface of the peripheral model being associated with a signal, which is an analog signal or a digital signal, an input signal or an output signal, matching an interface signal of the respective ECS component, said signal can be acquired from the respective interface of the respective ECS component; a signal operations module (225) configured to obtain, for simulating signal processing between the peripheral model (205), signal operations that represent signal processing between the respective ECS components, said signal operations including logical operations (230) for the digital signals, and mathematical operations (235) for the analog signals, thereby providing a unified framework for signal manipulation; a signal evaluation module (240) configured to use said evaluation of the signal processing to identify malfunctioning ECS components; and a malfunction detection module (240) configured to use said evaluation of the signal processing to identify malfunctions of the ECS components; and adapt the malfunctioning ECS component to function properly, ensuring continuous and reliable operation of the ECS.

The technical effects and definitions provided above for the disclosed method apply for the disclosed system. The signal abstraction module abstracts and categorizes signals into analog and digital groups, facilitating distinct processing paths and enhancing signal processing efficiency. The standardized interface module ensures accurate representation and seamless interaction between peripheral models and ECS components. The signal operations module provides a unified framework for signal manipulation through logical and mathematical operations, improving consistency and accuracy. The signal evaluation and malfunction detection modules enable quick and efficient identification and correction of malfunctions, ensuring continuous and reliable operation of the ECS. This comprehensive approach enhances system performance, reliability, and maintainability.

According to another aspect of the present disclosure, there is provided a computer program comprising instructions which, when the computer program is executed by a computer, cause the computer to carry out the methods discussed above.

According to another aspect of the present disclosure, there is provided a computer-readable data carrier having stored thereon the computer program disclosed above.

According to another aspect of the present disclosure, there is provided an apparatus comprising: one or more interfaces for communication; a memory; and a data processing circuit configured to carry out any one of the method described above.

Examples will now be further described with reference to the figures in which:
Fig. 1 shows a flow diagram illustrating a computer-implemented method 100 for virtualizing an electronic control system.
Fig. 2 shows a schematic illustrating the system used for virtualizing an electronic control system according to method 100.
Fig. 3 schematically illustrates a block diagram of an embodiment of an apparatus to execute the methods described herein.

### Detailed Description

The disclosed system comprises a signal abstraction module configured to abstract technical details of signals in ECS components, comprising categorizing said signals into groups. These groups include analog signals, which represent continuous values such as voltages, currents, and other analog measurements, and digital signals, which represent discrete values such as digital input/output (DIO) and pulse width modulation (PWM). This categorization facilitates distinct processing paths for different signal types or groups, ensuring that each type or group of signal is handled appropriately.

A signal operations module may be provided to create and implement signal operations to virtualize signal processing of the ECS components. For digital signals within the digital signals group, logical operations such as AND, OR, XOR, and NOT are defined. For analog signals within the analog signals group, mathematical operations such as multiplication (MUL) and addition (ADD) are used, implicitly allowing for division (DIV) and subtraction (SUB). These operations are implemented using prefix notation for wiring descriptions, wherein the operation is specified before its operands, enabling simple parsing and recursive evaluation of complex logical terms through pre-order traversal of a tree structure.

The system may further include a standardized interface module configured to encapsulate peripheral models of the ECS components behind a standardized interface. Each peripheral model has a number of pins equal to that in the corresponding ECS component, with each pin being associated with a signal. The signal can be an analog signal, such as voltage or current, or a digital signal, such as DIO or PWM. Each pin is identified by a unique name and designated as either input or output. This standardized interface allows for scalable integration of future peripheral models without major adjustments, ensuring compatibility and ease of integration.

A malfunction detection and correction module may be configured to identify and correct malfunctions in the ECS components. This module continuously monitors signals from various ECS components, detecting anomalies through predefined thresholds and patterns. It generates diagnostic trouble codes (DTCs) based on detected anomalies and analyzes sensor data to identify specific issues such as sensor failures, wiring problems, or software glitches. Once a malfunction is identified, the module applies corrections through software-based methods, including recalibration, firmware updates, and reset commands, as well as hardware-based methods, such as signal re-routing, component replacement, and wiring repairs. Corrections are integrated into both the virtual environment and the corresponding real-life ECS components, ensuring continuous and reliable operation of the ECS.

During startup, a validation module may perform comprehensive validation checks to ensure the virtual model accurately represents the real hardware. These checks include syntax checks to ensure correct use of parentheses, semantic checks to ensure operations are correct (including a maximum of one PWM signal per operation), compatibility checks to ensure no mixing of incompatible signal types or groups, and consistency checks to ensure connections are valid, such as not connecting input to input or output to output.

The system may also include a signal processing module configured to process signals in a sequence to ensure up-to-date or updated data. This involves sorting nodes and edges in the graph to ensure each node is processed only after all its dependencies have been processed, and using a pre-order traversal method to evaluate the tree structure, allowing for short-path evaluation of operations. Additionally, a feedback module may be provided to use the evaluated signals to provide feedback on the functionality of the ECS components under various simulated conditions, thereby enabling continuous monitoring and optimization of the electronic control unit (ECU) performance.

This comprehensive system and method for virtualizing and abstracting ECS components enhance the development, testing, and validation processes, ensuring the reliability and efficiency of the automotive system.

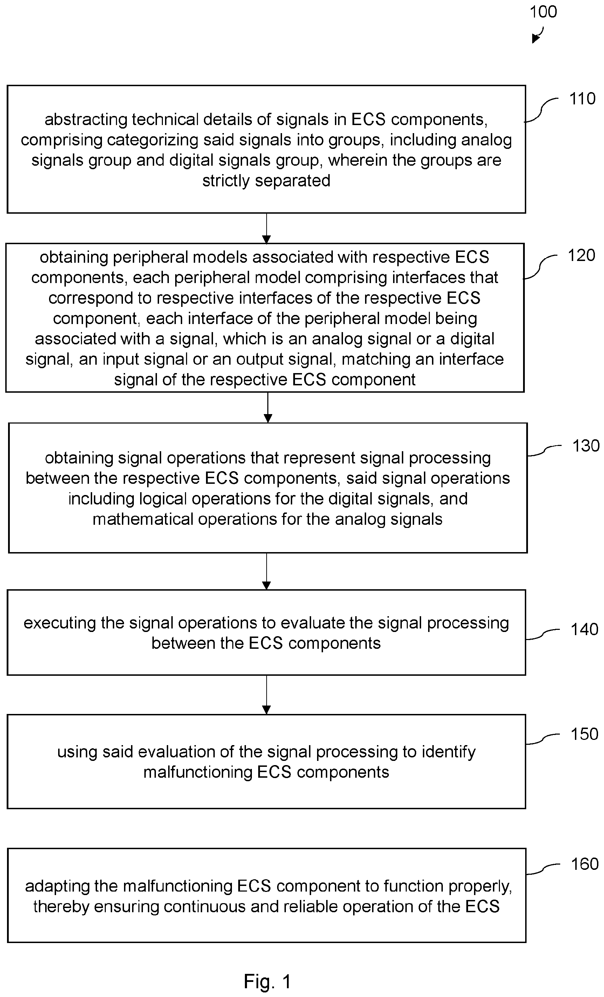

Fig. 1 shows a flow diagram illustrating a computer-implemented method 100 for virtualizing an electronic control system.

Step 110 of method 100 comprises abstracting technical details of signals in ECS components, comprising categorizing said signals into groups, including analog signals group and digital signals group, thereby facilitating distinct processing paths for different signal groups.

In embodiments, the groups may be strictly separated. In embodiments the analog signals may comprise continuous signals, for instance at least one of voltage signals and current signals. The digital signals may comprise discrete signal, for instance at least one of digital input/output, DIO, signals and pulse width modulation PWM signals.

In the context of automotive systems, an ECS refers to a comprehensive framework that manages and controls various electronic components and subsystems within an electric vehicle. The ECS may be responsible for ensuring the efficient and coordinated operation of these components, which include sensors, actuators, and control units. For example, an ECS might manage the vehicle's battery management system (BMS), which includes components such as voltage sensors, current sensors, and thermal sensors. By monitoring and adjusting the performance of these components, the ECS helps to optimize battery performance and ensure safety.

An Electronic Control Unit (ECU), also known as an electronic control module (ECM), is an embedded system within automotive electronics that controls one or more of the electrical systems or subsystems in a vehicle. Modern electric vehicles are equipped with numerous ECUs, each dedicated to specific functions. Examples of ECUs include the motor control unit (MCU), which manages the performance of the electric motor; the battery management system (BMS), which oversees the operation and health of the battery pack; and the power electronics controller (PEC), which regulates the flow of electrical energy between the battery and the motor. These ECUs work together to ensure the vehicle operates smoothly and efficiently under various driving conditions.

The components of an ECU in electric vehicles are critical for its operation and functionality. Key components include the microcontroller, which serves as the central processing unit; memory components such as SRAM, EEPROM, and Flash, which store data and software; and various input and output interfaces. The ECU collects data from sensors placed throughout the vehicle, such as voltage sensors, current sensors, and temperature sensors. It processes this data in real-time to make adjustments to parameters such as motor speed, battery charging and discharging rates, and thermal management, to optimize performance and ensure safety. Additionally, the ECU communicates with other control units in the vehicle, such as those responsible for regenerative braking and climate control, to coordinate vehicle responses and enhance efficiency and performance.

An Electronic Control System (ECS) according to the present disclosure can also function as a zone control unit (ZCU) in electric vehicles. A zone control unit consolidates various functions within specific physical zones of the vehicle, streamlining communication and power distribution. For example, a zone control unit might manage the functions of the vehicle's front zone, including components such as the front lighting system, front sensors (e.g., radar and lidar for advanced driver-assistance systems), and the front power distribution module. By localizing control within specific zones, the ZCU reduces wiring complexity, enhances system efficiency, and facilitates easier integration of new technologies. This zonal architecture supports the transition towards more centralized and scalable vehicle electronic systems, ultimately contributing to the development of software-defined vehicles.

The virtualization method described herein offers significant advantages for both ECUs and ZCUs by abstracting and simplifying the technical details of their components. By abstracting real-world signal properties, such as ignoring transient behaviors, assuming ideal physical conditions, and representing signal values in simplified forms (e.g., floating-point for voltage/current, binary for DIO, and percentage for PWM duty cycles), the method reduces complexity and facilitates easier analysis. This approach enables more efficient signal processing and integration of new technologies. For ECUs, it improves performance and reliability through streamlined software updates and recalibrations. For ZCUs, it reduces wiring complexity and enhances system scalability, allowing for more centralized control and easier maintenance. Overall, this abstraction and simplification facilitate continuous monitoring and optimization, ensuring that both ECUs and ZCUs operate effectively and adapt to evolving vehicle requirements.

Step 120 of method 100 comprises obtaining peripheral models associated with respective ECS components, wherein each peripheral model comprises interfaces that correspond to respective interfaces of the respective ECS component, each interface of the peripheral model being associated with a signal, which is an analog signal or a digital signal, an input signal or an output signal, matching an interface signal of the respective ECS component.

In embodiments, said signal may be acquired from the respective interface of the respective ECS component, meaning that the signal may be directly obtained from the physical interface where the ECS component connects to the respective peripheral models. This acquisition can occur in various ways, such as through direct measurement of electrical signals (e.g., voltage or current) at the interface, digital data retrieval from communication protocols (e.g., CAN bus, LIN bus), and/or sensor readings from connected devices. For example, in an Anti-lock Braking System (ABS), the wheel speed sensor's signal is acquired directly from the sensor's interface, which measures the rotational speed of the wheel and sends this data to the ABS controller. This direct acquisition ensures that the peripheral model accurately reflects the real-world signal characteristics, enabling precise simulation and analysis.

In embodiments, each interface may be designated as either input interface or output interface matching the interface of the respective ECS component. I embodiments, the input interface may be a read-write interface and the output interface may be a read-only interface.

In embodiments each peripheral model is assigned a number of interfaces equal to or corresponding to the number of interfaces of the respective ECS component. In embodiments, the assigned number of interfaces corresponding to the interfaces of the respective ECS component may be equivalent to the number of pins of said ECS component, each interface of the peripheral model may be associated with a signal, the signal may be an analog signal (e.g. voltage, current) or a digital signal (e.g. DIO, PWM), each itnerface may be identified by a unique name, and each interface may be designated as either input (e.g. read-write) or output (e.g. read-only). This structured approach ensures that the peripheral models accurately reflect the real-world ECS components, facilitating seamless integration and testing within the virtual environment.

In other embodiments, the peripheral models In embodiments, the peripheral models may be black box models wherein only the connections between said models represent the connections between the respective ECS components. In embodiments, the peripheral models can be obtained using various techniques such as software code, simulation, and artificial intelligence including machine learning algorithms. For instance, software code can be used to define the behavior and interfaces of the peripheral models. Simulation tools, like SystemC or MATLAB/Simulink, can be employed to model and test the peripherals in a virtual environment. AI techniques can also be utilized to optimize the design and functionality of the peripheral models by analyzing large datasets and learning from them.

An example of a model peripheral is a Battery Management System (BMS) in an electric vehicle. The BMS peripheral model would include interfaces corresponding to the actual BMS component, such as voltage sensors, current sensors, and thermal sensors. Each interface (or pin) would be associated with a specific signal type or group, such as analog signals for voltage and current, and digital signals for status indicators (e.g., DIO, PWM). Each pin would be uniquely named and designated as either input (read-only) or output (read-write), ensuring accurate representation and interaction within the virtual ECS.

Additionally or alternatively, according to the present disclosure, the peripheral models can be created without using any algorithms. The peripheral models may be developed by simply abstracting the function or signal processing of the corresponding ECS component and using logical functions to simulate them, for instance, or simply replicating the input signals and outputs signals of the ECS components to the respective peripheral models, as described herein in the following steps of method 100. For example, a peripheral model for a temperature sensor could either measure the input output reading and assign it to the respective peripheral model, or may be created by abstracting its function to generate a temperature reading based on predefined conditions and using logical functions to simulate its behavior in response to changes in the environment. This approach simplifies the creation of peripheral models, making it accessible and efficient while still providing accurate and useful simulations for the ECS.

Step 130 of method 100 comprises obtaining, for simulating signal processing between the peripheral models, signal operations that represent signal processing between the respective ECS component, said signal operations including logical operations for the digital signals, and mathematical operations for the analog signals, thereby providing a unified framework for signal manipulation.

In embodiments, the logical operations may include at least one of: including AND, OR, XOR, and NOT for the digital signals. The mathematical operations may include at least one of multiplication, MUL, and addition, ADD, division, DIV, and subtraction, SUB.

The step of obtaining signal operations for simulating signal processing between the peripheral models may involve creating a set of operations that abstract or virtualize the signal processing between the respective ECS components. These signal operations may include logical operations for digital signals and mathematical operations for analog signals, providing a unified framework for signal processing. Said signal operations may represent the flow of signals or the signal processing between said ECS components, said signal operations may not replicate each single operation inside the ECS component. Instead, they either simplify the input-output relationship, replicating the output as a function of the input, or they read, measure, map and/or replicate the input signals at respective input interfaces of the respective peripheral models, and/or they read, measure, map and/or replicate the output signals at respective output interfaces of the respective peripheral models.

According to the disclosed method, the signal operations may abstract the (e.g. complex) internal signal-processing or processes of the ECS components into simplified input-output operations, or may simply read or measure the input and output signals of the ECS components and assign them to the respective peripheral models, thereby making the peripheral model as a black box. This means that instead of modeling every internal detail of the component, the virtual system of the method may either focus on the relationship between the inputs and the resulting outputs, or may simply read and replicate the input and output signals of the ECS components to the respective peripheral models. This approach reduces complexity and quickly identifies malfunctions in the real-world ECS components.

In the context of quick and efficient malfunction detection, the method can be applied to the Battery Management System (BMS) of electric vehicles. The BMS receives inputs such as voltage and current measurements from individual battery cells and provides outputs like State of Charge (SOC) and State of Health (SOH) indicators. For analog operations, the method uses mathematical operations to process these inputs. For instance, averaging the voltage and current values can determine the overall state of the battery pack. An example averaging operation might be: SOC = AVG(Voltage, Current). This operation abstracts the detailed electrochemical processes within the battery cells, focusing instead on the input measurements to provide a simplified and essential output for monitoring the battery pack.

For digital operations, the method employs logical operations to detect malfunctions. For example, a logical operation can determine if any cell voltage exceeds safe limits, triggering a warning signal. An example operation might be: Warning = OR(Voltage1 > Threshold, Voltage2 > Threshold). This operation checks if either of two voltage readings (Voltage1 or Voltage2) exceeds a safe limit (Threshold). If either voltage is too high, the system triggers a warning. This helps quickly identify potential issues for further investigation. For example, in a Battery Management System (BMS), if any battery cell voltage exceeds the safe limit, the system alerts to prevent damage or hazards. This operation simplifies the detection of potential issues by focusing on critical thresholds, ensuring that any deviations are quickly identified and flagged for further investigation.

By abstracting the complex internal signal processing and focusing on the input-output relationships, the method enables efficient and accurate malfunction detection. This approach ensures that the BMS can quickly identify and respond to potential issues, maintaining the reliability and safety of the electric vehicle.

In another embodiment, in the context of quick and efficient malfunction detection, the method can be applied to the BMS of electric vehicles. The BMS receives inputs such as voltage and current measurements from individual battery cells and provides outputs like State of Charge (SOC) and State of Health (SOH) indicators. For analog operations, the method may passively replicate the measured input values and output values at respective pins of the ECS components and replicates them to the respective input and output of the respective peripheral models. For instance, the voltage and current values from the battery cells are directly replicated to the peripheral model without any internal processing. This passive replication abstracts the detailed electrochemical processes within the battery cells, focusing instead on the input measurements to provide a simplified and essential output for monitoring the battery pack.

For digital operations, the method employs logical operations to detect malfunctions. For example, a logical operation can determine if any cell voltage exceeds safe limits, triggering a warning signal. An example operation might be: Warning = OR(Voltage1 > Threshold, Voltage2 > Threshold). This operation simplifies the detection of potential issues by focusing on critical thresholds, ensuring that any deviations are quickly identified and flagged for further investigation. By passively replicating the digital input values and output values at respective pins of the ECS components to the respective input and output of the peripheral models, the method abstracts the complex internal signal processing and focuses on the input-output relationships. This approach ensures that the BMS can quickly identify and respond to potential issues, maintaining the reliability and safety of the electric vehicle.

In another embodiments, in the context of quick and efficient malfunction detection, the method can be applied to the Motor Controller Unit (MCU) of electric vehicles. The MCU receives inputs such as throttle position (a digital input/output (DIO) signal) and battery voltage (an analog signal) and provides outputs like motor speed (a pulse width modulation (PWM) signal) and torque (an analog signal). For analog operations, the method may passively replicate the measured input values and output values at respective pins of the ECS components and replicates them to the respective input and output of the respective peripheral models. For instance, the throttle position and battery voltage values are directly replicated to the peripheral model without any internal processing.

For digital operations, the method may employ logical operations to detect malfunctions. For example, a logical operation can determine if the battery voltage is above a minimum threshold, ensuring safe operation. An example operation might be: Motor Speed = AND(Throttle Position, Battery Voltage > Min Voltage). This operation simplifies the detection of potential issues by focusing on critical thresholds, ensuring that any deviations are quickly identified and flagged for further investigation. By passively replicating the digital input values and output values at respective pins of the ECS components to the respective input and output of the peripheral models, the method abstracts the complex internal signal processing and focuses on the input-output relationships. This approach ensures that the MCU can quickly identify and respond to potential issues, maintaining the reliability and safety of the electric vehicle. By abstracting the signal operations to simplified input-output relationships, the system can efficiently virtualize and process signals from various ECS components. This approach reduces complexity, enhances scalability, and ensures accurate simulation and control of the ECS components in electric vehicles. The examples provided illustrate how different ECS components and their connections can be effectively managed using this method.

Step 140 of method 100 comprises executing the created signal operations to evaluate the signal processing between the ECS components.

This step applies the defined logical operations (e.g., AND, OR, XOR, NOT) to digital signals and mathematical operations (e.g., multiplication (MUL), addition (ADD)) to analog signals. By doing so, the method can process and analyze the signals in a structured manner, ensuring accurate evaluation of the ECS components' performance. This implementation allows for the detection of anomalies or malfunctions by comparing the processed signals against expected values, thereby facilitating timely adjustments and maintenance.

For example, consider a scenario where the ECS includes a Transmission Control Unit (TCU) and an Engine Control Unit (ECU). The TCU sends a digital signal indicating the current gear position, which is processed using logical operations. If the TCU sends a signal indicating that the vehicle is in "Drive" (represented by a digital signal), the logical operation AND can be used to combine this signal with another digital signal from the brake pedal sensor. The combined signal ensures that the vehicle can only start if both the gear is in "Drive" and the brake pedal is pressed. This logical operation ensures safety by preventing the vehicle from starting in an incorrect gear.

In the context of an electric car, a Zonal Control Unit (ZCU) serves as an example of how this step is applied. A ZCU manages various functions within a specific zone of the vehicle, such as the front or rear zone. For instance, in the front zone, the ZCU might handle the integration and control of components like the front lighting system, radar and lidar sensors for advanced driver-assistance systems (ADAS), and the front power distribution module. By abstracting the ZCU components into corresponding peripheral components, as explained above, and executing the created signal operations to the peripheral components, the method can evaluate the signals from these components, ensuring they operate correctly and efficiently. For example, the method can process signals from the radar sensors to detect obstacles and adjust the vehicle's speed or direction accordingly. Similarly, it can evaluate the signals from the lighting system to ensure proper illumination based on driving conditions. This structured evaluation process enhances the overall performance and reliability of the electric vehicle's electronic systems.

Step 150 of method 100 comprises using said evaluation of the signal processing to identify malfunctions of one or more of the ECS components.

By analyzing the processed analog and digital signals and the evaluation of the signal processing, the system can detect deviations from expected values or patterns that indicate potential issues. For example, if the evaluated signal from a temperature sensor in the battery management system (BMS) shows an abnormal rise in temperature, it could indicate a malfunctioning cooling system or an overheating battery cell. Similarly, if the evaluated signal from a motor control unit (MCU) shows irregular motor speed fluctuations, it might suggest issues with the motor or its associated electronics.

Step 160 of method 100 comprises adapting the malfunctioning ECS component to function properly, thereby ensuring continuous and reliable operation of the ECS.

This step may be helpful for maintaining the overall functionality and safety of the vehicle. Once a malfunction is identified through the evaluation of signals, the method takes corrective actions to address the issue. These actions can be software-based, such as recalibrating parameters, updating firmware, or sending reset commands, or hardware-based, such as rerouting signals, replacing faulty components, or repairing damaged wiring. The goal is to identify malfunctions in ECS components quickly and efficiently, and restore the ECS component to its optimal working condition, for instance, also by simulating different scenarios in the corresponding peripheral module, preventing further issues and ensuring the vehicle continues to operate smoothly.

For example, consider a scenario where the battery management system (BMS) of the ECU detects an abnormal rise in temperature due to a malfunctioning cooling system. The method might first attempt a software-based correction by recalibrating the cooling system's control parameters to enhance its performance. If the issue persists, the method could send a reset command to reinitialize the cooling system. In cases where software corrections are insufficient, the method might identify the need for hardware-based corrections, such as rerouting signals to bypass the malfunctioning cooling component or replacing the faulty cooling unit altogether. These adaptive measures ensure that the ECS component functions properly, maintaining the vehicle's safety and performance.

By adapting malfunctioning peripheral models representing ECS components promptly, the method aims at minimizing downtime and preventing potential cascading failures that could affect other vehicle systems. This proactive approach enhances the reliability and longevity of the vehicle's electronic systems. Additionally, it ensures that the vehicle meets safety and performance standards, providing a better driving experience for the user. Continuous monitoring and adaptive corrections also facilitate predictive maintenance, allowing issues to be addressed before they lead to critical failures, thereby reducing maintenance costs and improving overall vehicle efficiency.

In embodiments, adapting the malfunctioning ECS component to function properly comprises software-based corrections and/or hardware-based corrections.

In embodiments, the software-based corrections may comprise at least one of: recalibration by adjusting software parameters to correct minor deviations of the malfunctioning ECS components output or the associated peripheral models output, firmware updates by applying updates to fix software bugs or improve performance to malfunctioning ECS components, and reset commands by sending reset commands to reinitialize malfunctioning ECS components or associated peripheral models. The hardware-based corrections may comprise at least one of: signal re-routing comprising sending signals to the corresponding malfunctioning ECS component or associated peripheral model to temporarily reroute signals to bypass the malfunctioning ECS components or the associated peripheral model, component replacement comprising identifying a need for physical replacement of faulty sensors or actuators in or for the malfunctioning ECS components or associated peripheral models and sending a feedback to a user, and wiring repairs comprising detecting and suggesting repairs for damaged or corroded wiring inside and/or outside the malfunctioning ECS component or associated peripheral model.

In this disclosure the term "ECS component" mentioned herein (e.g. in any embodiment) may denote or be equivalent to the peripherical model representing or associated with said ECS component.

In embodiments, the method for virtualizing an electronic control system may further comprise: abstracting (e.g. real-world) signal properties of the ECS components to reduce complexity and facilitate analysis, including simplifying transient behaviors (e.g. not considering transient behaviors) and assuming ideal physical influencing factors, thereby enabling more efficient signal processing.

In embodiments, abstracting (e.g. real-world) signal properties of the ECS components may further comprise: representing the accuracies of analog signal values (e.g. voltage and current technical signals) as floating-point values; and representing digital signal values (e.g. digital input/output, DIO, signal values) as binary states (e.g. instead of discrete levels, e.g. voltage and current levels). In embodiments, said abstracting of (e.g. real-world) signal properties of the ECS components may further comprise using duty cycle of a pulse width modulation, PWM, signal instead of simulating its state changes directly.

In embodiments, said abstraction of (e.g. real-world) signal properties may include simplifying transient behaviors, such as not considering transient behaviors, and assuming ideal physical influencing factors. By doing so, the method enables more efficient signal processing. For example, in a real-world scenario, the transient behavior of a temperature sensor might involve slight fluctuations in the signal due to environmental changes. By not considering said transient behaviors and assuming ideal conditions, the method simplifies the signal processing, making it more straightforward and efficient.

In further embodiments, abstracting signal properties of the ECS components may involve representing the accuracies of analog signal values, such as voltage and current technical signals, as floating-point values. This approach allows for precise and consistent representation of analog signals, facilitating accurate mathematical operations. For instance, a temperature sensor's output voltage can be represented as a floating-point value, ensuring that any calibration or adjustment operations are performed with high precision.

Additionally, the method may represent digital signal values, such as digital input/output (DIO) signal values, as binary states (e.g. instead of discrete or continuous voltage or current levels). This abstraction simplifies the processing of digital signals by focusing on their logical states rather than their physical voltage levels. For example, a digital signal indicating whether a fan is on or off can be represented as a binary state (0 or 1), making it easier to apply logical operations like AND, OR, and NOT.

In further embodiments, the abstraction of real-world signal properties of the ECS components may include using the duty cycle of a pulse width modulation (PWM) signal instead of simulating its state changes directly. By representing the PWM signal in terms of its duty cycle, the method avoids the complexity of simulating the rapid state changes of the signal. For instance, a PWM signal controlling the speed of a fan can be abstracted to its duty cycle percentage, simplifying the analysis and processing of the signal.

These abstractions collectively contribute to a more efficient and manageable virtualization of the ECS, enabling accurate and reliable signal processing while reducing the complexity associated with real-world signal properties.

In embodiments, the logical operations may include at least one of AND, OR, XOR, and NOT for digital signals, and the mathematical operations include at least one of multiplication, MUL, and addition, ADD, for analog signals.

In embodiments, executing the signal operations to evaluate the signal processing between the ECS components may comprise i) implementing the signal operations using prefix notation for wiring descriptions, wherein each signal operation is specified before its operands to enable simple parsing and recursive evaluation of complex logical terms representing the signal processing between the ECS components, and ii) performing signal processing evaluation via pre-order traversal of a tree structure.

In embodiments, implementing the signal operations using prefix notation for wiring descriptions may comprise: describing wiring of signals between the ECS components using prefix notation, wherein each signal operation is specified before its operands; parsing the prefix notation to construct a tree structure representing the signal operations; and performing signal processing evaluation via pre-order traversal of the tree structure, ensuring efficient processing and accurate evaluation of complex logical terms.

In embodiments, implementing the signal operations using prefix notation for wiring descriptions may comprise: each signal operation is specified before its operands, which enables simple parsing and recursive evaluation of complex logical terms representing the signal processing between the ECS components. For example, consider a logical operation where a fan should turn on if both the temperature is above a threshold and the enable signal is active. Using prefix notation, this operation can be described as: (AND FanOn (GT Temperature Threshold) EnableSignal). In this notation, the AND operation is specified before its operands, facilitating straightforward parsing and evaluation. In this context, GT stands for greater than, i.e. check if the temperature is greater than the threshold.

Furthermore, the signal processing evaluation may be performed via pre-order traversal of a tree structure. This may involve constructing a tree where each node represents a signal operation, and the branches represent the operands. By traversing this tree in pre-order (e.g. visiting the root node first, then recursively visiting the left and right subtrees), the method ensures efficient processing and accurate evaluation of the signal operations. For instance, the above example can be represented as a tree with the AND operation as the root, and the GT and EnableSignal as its children nodes.

In embodiments, implementing the signal operations using prefix notation for wiring descriptions may comprise describing the wiring of signals using prefix notation, wherein each signal operation is specified before its operands. This approach simplifies the parsing process, as the structure of the operations is clear and unambiguous. The method then involves parsing the prefix notation to construct a tree structure representing the signal operations. For example, a logical operation to determine if a system should activate based on multiple conditions can be described as: (OR SystemActivate (AND Condition1 Condition2) (XOR Condition3 Condition4)). This notation specifies the OR operation first, followed by its operands, which include an AND operation and an XOR operation. Parsing this notation constructs a tree where the OR operation is the root, and the AND and XOR operations are its children.

The final step may involve performing signal processing evaluation via pre-order traversal of the tree structure. This ensures that each operation is evaluated in the correct order, starting from the root and moving down to the leaves. By visiting each node and evaluating its operation before its operands, the method guarantees efficient processing and accurate evaluation of complex logical terms. For example, in the tree constructed from the above notation, the OR operation is evaluated first, followed by the AND and XOR operations, ensuring that all conditions are correctly processed.

These embodiments provide a structured and efficient approach to evaluating signal processing in ECS components, leveraging prefix notation and tree traversal to handle complex logical operations with ease.

In embodiments, the method for virtualizing an ECS may further comprise performing validation checks during startup of the method or of a system executing the method, wherein the validation checks include at least one of syntax checks, semantic checks, compatibility checks, and consistency checks, thereby ensuring the peripheral models accurately represents the respective ECS components.

In embodiments, the validation checks during startup may further comprise: performing syntax checks to ensure correct use of parentheses; performing semantic checks to ensure operations are correct, (e.g. including checking that a maximum of one PWM signal per operation is present); performing compatibility checks to ensure no mixing of incompatible signal groups; and performing consistency checks to ensure connections are valid, comprising not connecting input to input or output to output.

For example, during the startup phase, the system might perform a series of checks to verify that the peripheral models are correctly defined and that there are no errors in the signal processing logic.

In further embodiments, the validation checks during startup may comprise performing syntax checks to ensure the correct use of parentheses. This involves verifying that all parentheses are properly matched and nested, which is crucial for correctly parsing and evaluating the signal operations. For instance, a syntax check might identify an error if an operation is missing a closing parenthesis, ensuring that the signal operations are syntactically correct before execution.

Additionally, the validation checks may include performing semantic checks to ensure that the operations are correct. This involves verifying that the operations make logical sense and adhere to predefined rules. For example, a semantic check might ensure that there is a maximum of one pulse width modulation (PWM) signal per operation, preventing conflicts and ensuring that the signal processing logic is semantically valid.

Compatibility checks are also performed to ensure that there is no mixing of incompatible signal groups. This involves verifying that signals from different groups, such as analog and digital signals, are not incorrectly combined in a single operation. For example, a compatibility check might flag an error if an analog signal is mistakenly used in a digital operation, ensuring that the signal groups remain distinct and correctly processed.

Finally, consistency checks are performed to ensure that connections are valid. This involves verifying that the connections between signals are logically consistent and do not violate any predefined rules. For instance, a consistency check might ensure that inputs are not connected to other inputs and outputs are not connected to other outputs, maintaining the integrity of the signal processing logic.

These validation checks collectively ensure that the peripheral models accurately represent the respective ECS components and that the signal processing logic is correctly defined and executed. By performing these checks during startup, the method ensures that any errors or inconsistencies are identified and addressed before the system begins operation, thereby enhancing the reliability and accuracy of the virtualized ECS.

In embodiments, the method for virtualizing an electronic control system may further comprise processing signals between the peripheral modesl in a sequence (e.g. using a Directed Acyclic Graph DAG) to ensure up-to-date or updated data. This may involve sorting nodes and edges in a graph to ensure that each node is processed only after all its dependencies have been processed. By organizing the nodes and edges in this manner, the method guarantees that data and/or signals between the peripheral models are processed in the correct order, matching or representing or abstracting the order of data and/or signals between the respective ECS components, thereby maintaining the accuracy and reliability of the ECS.

For example, consider a PCB where nodes represent ICs, such as a temperature sensor and a fan controller, and edges represent signal dependencies between these components. The temperature sensor provides an analog signal that must be processed before the fan controller can use this data to determine whether to activate the fan. In this scenario, the method sorts the nodes and edges so that the temperature sensor's data is processed first, followed by the fan controller. This ensures that the fan controller operates on the most recent temperature data, maintaining the system's reliability.

The method leverages the fact that the wiring does not contain cycles between peripherals, with the only feedback channel leading back to the microcontroller. This absence of cycles ensures that the system can stabilize. By sorting the nodes and edges, the method ensures that each node is processed in the correct sequence, starting from the microcontroller, activating the wires to transport signals to the next nodes, and repeating this process until the microcontroller is reached again.

For instance, in a graph representing the PCB, the microcontroller (µC) provides output data, which is then transported via wires to the next nodes, such as the temperature sensor. The temperature sensor processes its input data and sends the processed data to the fan controller. The fan controller then processes this data to determine whether to activate the fan. This sequence ensures that each node processes data only after its dependencies have been processed, maintaining up-to-date or updated data throughout the system.

This approach corresponds to a graph tree with levels, where each level represents a specific stage in the processing sequence. By organizing nodes into distinct hierarchical levels, the method ensures that dependencies are managed efficiently, with each node processing data only after its predecessors have completed their tasks. This structure guarantees that the ECS operates with accurate and up-to-date or updated data, enhancing the overall performance and reliability of the system.

In embodiments, combining the features of using prefix notation for wiring descriptions and processing signals in a sequence e.g. using a Directed Acyclic Graph (DAG) may result in a method that ensures efficient and accurate signal processing within an electronic control system (ECS). The use of prefix notation simplifies the parsing and recursive evaluation of signal operations. This approach allows each signal operation to be specified before its operands, facilitating straightforward parsing and evaluation. The pre-order traversal of a tree structure ensures that each signal operation is processed in a logical and orderly manner, enhancing the efficiency and accuracy of the signal processing.

Additionally, processing signals in a sequence using a DAG ensures that each node is processed only after all its dependencies have been resolved. This method involves sorting nodes and edges in the graph to maintain the correct processing order. By doing so, the method guarantees that data is updated correctly and consistently, thereby improving the reliability and accuracy of the ECS.

For example, consider an ECS with the following components and signals: Component A generates an analog signal S_A, Component B generates a digital signal S_B, and Component C processes signals S_A and S_B to produce an output signal S_C. Using prefix notation, the signal operations are described in a way that specifies each operation before its operands. For instance, if S_C is the result of adding S_A and the logical AND of S_B with another signal S_D, the prefix notation might be "ADD S_A (AND S_B S_D)". This notation is then parsed to construct a tree structure, which is traversed in pre-order to evaluate the signal processing.

Simultaneously, the signals are represented in a DAG to ensure proper sequencing. For example, if S_D depends on another signal S_E, the graph ensures S_E is processed before S_D. This ensures that each signal operation is processed only after all its dependencies have been resolved, leading to accurate and up-to-date data.

By combining these features, the method ensures that the signal processing within the ECS is both efficient and accurate, resulting in reliable and consistent operation of the system. This approach reduces complexity, enhances reliability, and ensures that the ECS functions properly under various conditions.

In embodiments, the method for virtualizing an ECS may further comprise: using the evaluated signals to provide feedback on the functionality of the ECS components under various simulated conditions, thereby enabling continuous monitoring and optimization of the electronic control unit (ECU) performance. This feedback mechanism enables continuous monitoring and optimization of the electronic control unit (ECU) performance. For example, the evaluated signals from a temperature sensor and a fan controller can be used to simulate different environmental conditions, such as varying temperatures. By analyzing the feedback, the system can identify potential issues and optimize the performance of the ECU, ensuring reliable and efficient operation under diverse conditions.

In embodiments, the method for virtualizing an ECS may be executed in a virtual environment (e.g. digital twin environment, cloud environment) that provides simulation and feedback, enabling continuous monitoring and optimization of the ECU performance under various simulated conditions. For instance, a digital twin of the ECS can replicate the physical system's behavior, allowing for quick analysis, malfunction detection, and corresponding adjustments. By leveraging the virtual environment, the method can simulate different scenarios, such as sudden temperature changes or component failures, and provide immediate feedback to optimize the ECU's response. This quick simulation and feedback loop ensures that malfunctions are quickly detected in the ECS, adapting to changing conditions and maintaining system reliability.

In embodiments, adapting the malfunctioning ECS component to function properly may comprise software-based corrections and/or hardware-based corrections. In embodiments, the software-based corrections comprise at least one of: recalibration by adjusting software parameters associated with the ECS components to correct minor deviations of the malfunctioning ECS components output, firmware updates by applying updates to fix software bugs or improve performance to malfunctioning ECS components, and reset commands by sending reset commands to reinitialize malfunctioning ECS components.

In embodiments, the hardware-based corrections may comprise at least one of: signal re-routing comprising sending signals to the corresponding malfunctioning ECS component to temporarily reroute signals to bypass the malfunctioning ECS components, component replacement comprising identifying a need for physical replacement of faulty sensors or actuators in the malfunctioning ECS components and sending a feedback to a user, and wiring repairs comprising detecting and suggesting repairs for damaged or corroded wiring inside and/or outside the malfunctioning ECS component.

Re-routing can be considered a form of repair in the context of the described method. While traditional repairs might involve the direct replacement or repair of the defective component, re-routing serves as an alternative solution by redirecting signals to bypass the faulty component. This ensures that the system continues to function correctly without the immediate need to physically replace or repair the defective component.

For example, if a control module for the headlights fails in a vehicle's lighting system, the system can permanently redirect the control signals to a replacement module within the zone control unit (ZCU). This re-routing effectively repairs the system by maintaining the functionality of the headlights, thereby ensuring safety and reliability without requiring immediate physical intervention. This approach leverages the redundancy and flexibility of the system to manage persistent faults and provide a practical and efficient repair solution.

In embodiments, recalibration may involve adjusting software parameters associated with the ECS components to correct minor deviations in the output of the malfunctioning components. For example, if a temperature sensor is providing slightly inaccurate readings, recalibration can adjust the software parameters to correct these deviations, ensuring accurate temperature measurements. Firmware updates involve applying updates to fix software bugs or improve the performance of the malfunctioning ECS components. For instance, a firmware update might resolve a bug causing intermittent failures in a fan controller, thereby enhancing its reliability. Reset commands involve sending reset commands to reinitialize malfunctioning ECS components, effectively restarting them to clear any temporary issues. For example, if a sensor becomes unresponsive, a reset command can reinitialize it, restoring normal operation.

In embodiments, the hardware-based corrections may comprise at least one of the following: signal re-routing, component replacement, and wiring repairs. Signal re-routing may involve sending signals to the corresponding malfunctioning ECS component to temporarily reroute signals and bypass the malfunctioning components. For example, if a specific sensor is malfunctioning, signals can be rerouted to bypass this sensor, allowing the system to continue operating while the issue is addressed. Component replacement involves identifying the need for the physical replacement of faulty sensors or actuators in the malfunctioning ECS components and sending feedback to a user. For instance, if a temperature sensor is found to be defective, the system can notify the user to replace the sensor, ensuring continued accurate temperature monitoring. Wiring repairs involve detecting and suggesting repairs for damaged or corroded wiring inside and/or outside the malfunctioning ECS component. For example, if a wire connecting a sensor to the microcontroller is found to be corroded, the system can suggest repairing or replacing the wire to restore proper connectivity and functionality.

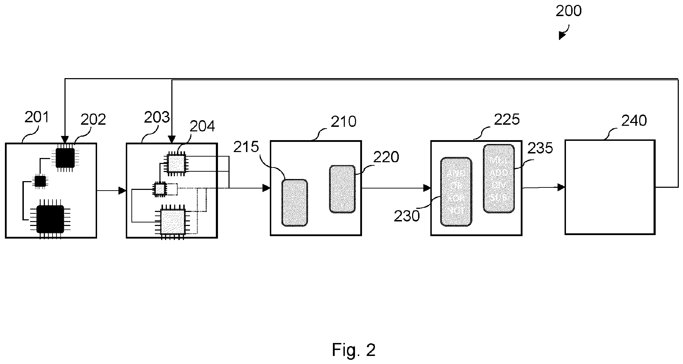

Fig. 2 shows a schematic illustrating the system used for virtualizing an electronic control system according to method 100.

The system for virtualizing and electronic control system, ECS, shown in Fig. 2 comprises: a signal categorization module (210) configured to categorize signals in ECS components (202) into categorized groups, including analog signals group (215) and digital signals group (220), wherein the groups may be strictly separated to facilitate distinct processing paths for different signal types or groups a standardized interface module (203) configured to encapsulate peripheral models (204) with respective ECS components (202), wherein each peripheral model comprises interfaces that correspond to respective interfaces of the respective ECS component, each interface of the peripheral model being associated with a signal, which is an analog signal or a digital signal, an input signal or an output signal, matching an interface signal of the respective ECS component, said signal can be acquired (e.g. measured, read, replicated, mapped, etc. e.g. in real-time) from the respective interface of the respective ECS component; a signal operations module (225) configured to obtaining, for each peripheral model (205), signal operations to virtualize signal processing of the respective ECS component, said signal operations including logical operations (230) for the digital signals, and mathematical operations (235) for the analog signals, thereby providing a unified framework for signal manipulation; a signal evaluation module (240) configured to use said evaluation of the signal processing to identify malfunctioning ECS components; and a malfunction detection module (240) configured to use said evaluation of the signal processing to identify malfunctions of the ECS components; and adapt the malfunctioning ECS component to function properly, ensuring continuous and reliable operation of the ECS.

All the definitions and examples provided for the steps, components, and features of method 100 apply for the system 200.

Further examples of the disclosed method are provided herein. For instance, the wiring of the components may be created based on a logical schematic. In this schematic, certain signal transformations may occur, such as a logical OR of multiple signals. In the virtual system or the peripheral models discussed above, each signal can be individually examined and debugged. The concrete steps to the method disclosed herein may include: Abstraction of a technical schematic to a logical schematic; Encapsulation of peripheral models behind a common interface; Abstraction of signals; Creation of logical and technical signal operations: and Wiring and recursive evaluation of networks.

Abstraction of a Technical Schematic to a Logical Schematic: It is not important which resistor and which transistor are used. What matters is what happens to the signal. Two groups of signals may be identified: A) Technical signals (voltages and currents) that can be transformed through technical operations (e.g., voltage divider), and B) Logical signals (digital IO and PWM) that can be transformed through logical operations (e.g., AND, OR, XOR, NOT). The two groups may be strictly separated, i.e. these signals cannot be connected.

Encapsulation of Peripheral Models Behind a Common Interface: Peripherals are smaller integrated circuits in a package that can be connected externally via pins. The vast number of different peripherals requires a scalable concept, allowing future peripherals to be added without needing to adjust the rest of the virtualization environment. Additionally, a project might switch to another derivative of a peripheral, which should cause minimal effort in virtualization. Therefore, the commonalities of all peripherals are used to define a common interface: Each peripheral (also called peripheral model throughout this disclosure) has a number of pins, where each pin: Transmits a signal of type DIO: Digital Input/Output, PWM: Pulse Width Modulation, SPI: Serial Peripheral Interface, Voltage, Current. Each pin is identified by a unique name, and each pin is either Input (read-write) or Output (read-only).

In the software, this peripheral may be represented in C++ through a pure virtual interface, but can also be implemented in other languages. Object-oriented languages may be more suitable for this purpose than procedural languages.

Abstraction of Signals (for the peripheral models): Some properties of signals that occur in the real world may be abstracted to reduce complexity and make the system easier to analyze: The transient behavior of signals is not considered (e.g., a switch from OFF to ON takes a few microseconds to stabilize in hardware). Physical influencing factors such as temperature or pressure are assumed to be ideal. The accuracies of Voltage and Current are represented as floating-point values. The values of DIO are 0 or 1 instead of 0V and 12V. A PWM signal changes its state faster than the simulation clock and therefore cannot be simulated 1:1. Instead, the percentage time share of a PWM signal is used. Said percentage time share may be called DutyCycle in hardware. However, said hardware DutyCycle may be reduced, from the real range from 0 to 8000, to the range of 0 to 100 to make debugging easier. If a PWM signal has 33% intensity, then 33% is easier to understand in the log than 2667. The accuracy remains sufficient for virtualization.

The timing behavior of virtualization or the peripheral models is different from that in the real world. This is mainly due to the resources (RAM, ROM) available to the virtual environment, but also because the 10ms clock from ECS such as ClassicAutosar cannot be virtualized, as such fine-grained timers are not available on a typical operating system. It follows that all real-time-related tests or expectations may not be guaranteed to be met at all times, as this may in some case defy the purpose of the approach disclosed herein, which is abstracting and simplifying complex systems and operations for quick and efficiency functionality validation purposes.

Creation of Logical and Technical Signal Operations: The goal of creating these operations is to virtualize all signal processing processes on the PCB. The following operations may be implemented: For Voltage and Current: To enable voltage dividers and amplifiers, at least one of the operations MUL, ADD, DIV and SUB may be used. Reading constant values that serve as factors or summands.

For DIO and PWM: The NOT operation negates a signal, meaning the signal type remains the same. The AND, OR, and XOR operations can be applied to multiple DIO signals and at most one additional PWM signal.

In addition, exploiting the fact that each operation yields exactly one result: This allows for the construction of DAG (Directed Acyclic Graph) tree structures. The root of the tree structure represents the result of the operation, while the leaves of the tree represent the input pins from which values are read.

Wiring and Recursive Evaluation of Networks: A prefix notation may be used to describe the wiring. For instance: The notation "A && B" as commonly used in C language, may be an infix notation because the operation is between the operands. Processing such a term is unnecessarily complicated when read from left to right. In contrast, the notation "AND(A, B)" is a prefix notation, as the operation is mentioned first, followed by the operands. This allows for very simple parsing of a complex logical term, always processed from left to right.

An example: An assignment to an InputPort (on the left side of the term) is described, created using a complex operation from multiple OutputPorts: "EFUSE_1_PIN_INO = AND( OR ( EFUSE_1__PIN_OUTO, NOT( EFUSE_1_PIN__OUT1 ) ), NOT ( EFUSE_1__PIN_OUT2 ) )".

Wiring is Generated During the Startup of the Virtual System: During this process, several checks may be performed, such as: is the syntax of the description correct (e.g., proper use of parentheses in terms). Is the semantics of the operations correct (e.g., max. 1 PWM signal per operation). Are the signals used compatible (e.g., no mixing of Voltage and DIO). Are the connections consistent (e.g., not connecting Input to Input or Output to Output).

The nodes of the tree, i.e., the operations, may be technically implemented using C++ features. Each node may contains function pointers that are bound using std::bind. For signal evaluation, these functions are called, and their results are evaluated and passed on until the entire tree has been evaluated.

Evaluation of such a tree structure may be done in pre-order traversal. This means descending recursively in a specific order. The acyclic nature of the tree is ensured since it is a DAG (direct acyclic graph). This method allows certain operations to be executed faster: If the first operand of an OR operation is TRUE, the result is also TRUE. If the first operand of an AND operation is FALSE, the result is also FALSE. Other traversal methods can also be used. However, they do not allow for the mentioned short-path evaluation of the operations.

The disclosed method offers robust virtualization, error analysis, and the integration of additional tools for signal visualization. Moreover, it is possible to automatically generate integration into external tools (e.g., Canoe) based on the virtualization configuration, simplifying and accelerating applicability in specific projects.

Another challenge arises when considering the entire PCB (Printed Circuit Board) and the dependencies between the ICs (Microcontroller and Peripherals). A PCB is a complex, interconnected graph where the nodes correspond to ICs and the edges represent dependencies. Therefore, edges are not wires, but signal dependencies. There can be 1 to n wires on which various operations can take place.

The solution provided herein is based on the fact that the wiring does not contain cycles between peripherals. The only feedback channel leads back to the microcontroller. If there were cycles between peripherals, the system would not be able to stabilize. Based on this fact, we sort the nodes and edges so that they are processed in the correct order. An processing examples includes the steps: The microcontroller provides output data. Wires leading from this node are activated to transport signals to the next nodes (including operations like AND, OR, etc.). The next node is triggered to process its input data. The outgoing wires are activated again. This strategy repeats until the microcontroller is reached again. The microcontroller processes the input data, and the cycle begins anew.

This approach corresponds to a graph tree with levels. The graph tree with levels organizes nodes into distinct hierarchical levels, where each level represents a specific stage in the processing sequence. This structure ensures that dependencies are managed efficiently, with each node processing data only after its predecessors have completed their tasks.

In the present disclosure, any feature described in an embodiment, example, method (e.g. method 100), method step, and/or system (e.g. system 200), may be combined with any feature of another embodiment, example, method, method step, and/or system unless otherwise specified.

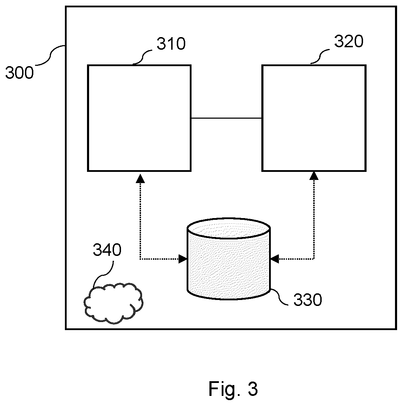

Fig. 3 schematically illustrates a block diagram of an embodiment of an apparatus 300 comprising one or more interfaces 310 for communication and one or more processors or data processing circuits 320 configured to execute any one of the methods described herein.

In embodiments, the apparatus may further comprise a memory or a storage medium 330. A storage medium 330 (or a data carrier, or a computer-readable data carrier, or a computer-readable medium) may comprise, stored thereon, a computer program or computer-executable instructions for performing one of the methods described herein when it is performed by one or more processors 320. The processors 320 may communicate with the storage medium 330 directly and/or via the one or more interfaces 310.

In embodiments, the one or more interfaces 310 may comprise wired and/or wireless interfaces for transmitting and/or receiving communication signals in connection with the execution of the proposed concept. In practice, the interfaces, e.g., comprise pins, wires, antennas, and/or the like. As well, the interfaces may comprise means for (analog and/or digital) signal or data processing in connection with the communication, e.g., filters, samples, analog-to-digital converters, signal acquisition and/or reconstruction means as well as signal amplifiers, compressors and/or any encryption/decryption means.

The data processing circuit 320 may correspond to or comprise any type of programable hardware. So, examples of the data processing circuit 320, e.g., comprise a memory, microcontroller, field programmable gate arrays, one or more central and/or graphical processing units. To execute the proposed method, the data processing circuit 320 may be configured to access or retrieve an appropriate computer program for the execution of the proposed method from a memory of the data processing circuit 320 or a separate memory which is communicatively coupled to the data processing circuit 320.

Some or all of the method steps described above with regard to Figures 1-2 may be implemented by a computer in that they are executed by (or using) a processor, a microprocessor, an electronic circuit, or the data processing circuit 320. For example, the implementation can be performed using a non-transitory storage medium such as a computer-readable storage medium or data carrier. Such computer-readable media include any media that can be accessed by either a general-purpose or a specialized computer system.

Furthermore, any component of apparatus 300 may be embedded locally on the autonomous system or located in the cloud 340. For instance, the data processing circuit (320) can be located in an edge device of the autonomous system, in the cloud 340 (e.g., a digital twin), or partially in both. Edge devices, equipped with edge AI capabilities, can perform real-time data processing and decision-making close to the source of data, reducing latency and improving response times. This is particularly helpful for autonomous systems that require immediate reactions to dynamic environments.

The cloud component 340 can leverage high-performance computing (HPC) resources and advanced machine learning models for more complex computations that are not time-sensitive. By utilizing cloud-based digital twins 340, which are virtual replicas of physical systems, the autonomous system can simulate various scenarios and optimize its performance based on real-time data and predictive analytics. This hybrid approach ensures that the system can handle both real-time processing and complex computations efficiently.

Additionally, the integration of 5G/6G technology (e.g. in communication interfaces 310) can further enhance this setup by providing high-speed, low-latency communication between the edge devices and the cloud 340. This ensures seamless data transfer and synchronization, enabling the autonomous system to make informed decisions quickly and accurately.

In summary, by combining edge AI, HPC, digital twins, and 5G/6G technology, the implementation of these methods becomes more robust, scalable, and efficient. This hybrid architecture not only enhances the performance and decision-making capabilities of the autonomous system but also ensures that it can adapt to various dynamic environments and scenarios effectively.

The apparatus 300 may also include a cloud implementation 340, which enhances its capabilities by leveraging cloud-based resources. This cloud implementation comprises several key components. The cloud implementation may comprise cloud interfaces 310' designed for communication between the local apparatus and the cloud. These interfaces enable data transfer, remote access, and integration with cloud services, ensuring seamless connectivity.

Additionally, the cloud implementation 340 may include cloud processors or data processing circuits 320'. These may be processing units located in the cloud, configured to execute any of the methods described for the apparatus. By utilizing cloud processors, the system can handle more complex computations and larger datasets without being limited by the local hardware's capabilities. This allows for greater flexibility and efficiency in processing tasks, as well as the ability to dynamically scale resources based on demand.

Furthermore, the cloud implementation 340 may include a cloud memory or storage medium 330' that may be responsible for storing data, datasets, and program/method code in the cloud. Cloud storage offers scalability, redundancy, and accessibility, ensuring that data is securely stored and can be accessed from anywhere. This enhances the overall reliability and availability of the system, providing robust data protection and disaster recovery options.

The cloud implementation 340 allows for flexibility in how the methods are executed. Specifically, any of the methods described herein can be partially executed in the cloud, where some parts of the method may be processed locally while others are offloaded to the cloud. This hybrid approach optimizes performance and resource utilization by balancing the load between local and cloud resources. Alternatively, the entire method can be fully executed in the cloud, leveraging the cloud's extensive computational power and storage capabilities. This dual implementation (local and cloud) ensures that the apparatus can efficiently handle a wide range of tasks, from simple local processing to complex cloud-based computations, providing a robust and scalable solution that can adapt to varying workloads and operational requirements.

## Claims

1. A computer-implemented method for virtualizing an electronic control system, ECS, comprising:
abstracting (110) technical details of signals in ECS components, comprising categorizing said signals into groups, including analog signals group and digital signals group, thereby facilitating distinct processing paths for different signal groups;
obtaining (120) peripheral models associated with respective ECS components, each peripheral model comprising interfaces that correspond to respective interfaces of the respective ECS component, each interface of the peripheral model being associated with a signal, which is an analog signal or a digital signal, an input signal or an output signal, matching an interface signal of the respective ECS component;
obtaining (130), for simulating signal processing between the peripheral models, signal operations that represent signal processing between the respective ECS component, said signal operations including logical operations for the digital signals, and mathematical operations for the analog signals;
executing (140) the signal operations to evaluate the signal processing between the ECS components;
using (150) said evaluation of the signal processing to identify malfunctions of one or more of the ECS components; and
adapting (160) the malfunctioning ECS components to function properly, thereby ensuring continuous and reliable operation of the ECS.

2. The method of claim 1, wherein abstracting the signal properties of the ECS components further comprises abstracting signal properties of the ECS components to reduce complexity and facilitate analysis, including simplifying transient behaviors and assuming ideal physical influencing factors, thereby enabling more efficient signal processing.

3. The method of claim 2, wherein abstracting the signal properties of the ECS components further comprises:
representing accuracies of analog signal values as floating-point values; and
representing digital signal values as binary states.

4. The method of any previous claim, wherein the logical operations include at least one of AND, OR, XOR, and NOT for digital signals, and the mathematical operations include at least one of multiplication, MUL, and addition, ADD, for analog signals.

5. The method of any previous claim, wherein executing the signal operations to evaluate the signal processing between the ECS components comprises:
implementing the signal operations using prefix notation for wiring descriptions, wherein each signal operation is specified before its operands to enable simple parsing and recursive evaluation of complex logical terms representing the signal processing between the ECS components; and
performing signal processing evaluation via pre-order traversal of a tree structure.

6. The method of claim 5, wherein implementing the signal operations using prefix notation for wiring descriptions comprises:
describing wiring of signals between the ECS components using prefix notation, wherein each signal operation is specified before its operands;
parsing the prefix notation to construct a tree structure representing the signal operations; and
performing signal processing evaluation via pre-order traversal of the tree structure, ensuring efficient processing and accurate evaluation of complex logical terms.

7. The method of any previous claim, further comprising performing validation checks during startup of the method or of a system executing the method, the validation checks including at least one of syntax checks, semantic checks, compatibility checks, and consistency checks, thereby ensuring the peripheral models accurately represents the respective ECS components.

8. The method of claim 7, wherein the validation checks during startup further comprise:
performing syntax checks to ensure correct use of parentheses in the signal operations;
performing semantic checks to ensure the signal operations are correct;
performing compatibility checks to ensure no mixing between the analog signals group and the digital signals group; and
performing consistency checks to ensure connections between the peripheral models are valid, comprising not connecting input to input or output to output.

9. The method of any previous claim, further comprising processing signals between the peripheral models in a sequence to ensure updated data, including sorting nodes and edges in a graph to ensure each node is processed only after all its dependencies have been processed.

10. The method of any previous claim, wherein adapting the one or more malfunctioning ECS component to function properly comprises software-based corrections and/or hardware-based corrections.

11. The method of claim 10, wherein the software-based corrections comprise at least one of:
recalibration by adjusting software parameters associated with the malfunctioning ECS components to correct minor deviations of the components output;
firmware updates by applying updates to fix software bugs or improve performance to the malfunctioning ECS components; and
reset commands by sending reset commands to reinitialize malfunctioning ECS components, and/or
wherein the hardware-based corrections comprise at least one of:
signal re-routing comprising sending signals to the corresponding malfunctioning ECS component to temporarily reroute signals to bypass the malfunctioning ECS components,
component replacement comprising identifying a need for physical replacement of faulty sensors or actuators in the malfunctioning ECS components and sending a feedback to a user, and
wiring repairs comprising detecting and suggesting repairs for damaged or corroded wiring inside and/or outside the malfunctioning ECS component.

12. A system for virtualizing and electronic control system, ECS, comprising:
a signal abstraction module (210) configured to abstract signals in ECS components (202), comprising categorizing said signals into categorized groups, including analog signals group (215) and digital signals group (220), thereby facilitating distinct processing paths for different signal groups;
a standardized interface module (203) configured to encapsulate peripheral models (204) with respective ECS components (202), each peripheral model comprising interfaces that correspond to respective interfaces of the respective ECS component, each interface of the peripheral model being associated with a signal, which is an analog signal or a digital signal, an input signal or an output signal, matching an interface signal of the respective ECS component;
a signal operations module (225) configured to obtain, for simulating signal processing between the peripheral models (205), signal operations that represent signal processing between the respective ECS components, said signal operations including logical operations (230) for the digital signals, and mathematical operations (235) for the analog signals, thereby providing a unified framework for signal manipulation;
a signal evaluation module (240) configured to use said evaluation of the signal processing to identify malfunctioning ECS components; and
a malfunction detection module (240) configured to use said evaluation of the signal processing to identify malfunctions of the ECS components; and adapt the malfunctioning ECS component to function properly, ensuring continuous and reliable operation of the ECS.

13. A computer program comprising instructions which, when the computer program is executed by a computer, cause the computer to carry out a method of any one of claims 1 to 11.

14. A computer-readable data carrier having stored thereon the computer program of claim 13.

15. An apparatus (300) comprising:
one or more interfaces (310) for communication;
a memory (330); and
a data processing circuit (320) configured to carry out the method of any one of claims 1 to 11.
